# EUROPEAN PATENT APPLICATION

(11) **EP 0 902 474 A2**
(43) Date of publication of application: **17.03.1999**
(21) Application number: 98307358.6
(22) Date of filing: 11.09.1998
(51) Int. Cl.: H01L 23/525

(54) **Improved laser fuse links and methods therefor**

(30) Priority: 12.09.1997 US 928047
(71) Applicant: SIEMENS AKTIENGESELLSCHAFT, 80333 München (DE); International Business Machines Corporation, Armonk, N.Y. 10504 (US)
(72) Inventor: Weigand, Peter, Croton On Hudson, NY 10520 (US); Kiewra, Edward W., Verbank, NY 12585 (US); Narayan, Chandrasekhar, Hopewell Junction, NY 12533 (US); Arndt, Kenneth C., Poughkeepsie, NY 12601 (US); Lachtrupp, David, Waterbury Center, VT 05677 (US); Gilmour, Richard Alfred, Colchester, VT 05446 (US); Palagonia, Anthony Michael, Underhill, VT 05489 (US)
(74) Representative: Vigars, Christopher Ian

(57) **Abstract**

A dynamic random access memory integrated circuit implemented on a silicon substrate. The dynamic random access memory integrated circuit includes a main memory array having main memory array elements, and a redundant memory array coupled to the main memory array. The redundant memory array includes redundant memory array elements, each of the redundant memory array elements being configured to replace a defective one of the main memory array elements. The dynamic random access memory integrated circuit includes a plurality of laser fuse links (202, 204, 206, and 208) coupled to the redundant memory array. A first laser fuse link of the plurality of laser fuse links is configured to be modified by a laser beam during fabrication of the dynamic random access memory integrated circuit to set a value of an address fuse for a first one of the redundant memory array elements. The dynamic random access memory integrated circuit also includes a plurality of shielding portions (402, 404, 406, and 408) underlying the laser fuse links. The shielding portions are configured to substantially minimize laser-induced damage from the laser beam to a first area underlying the shielding portion when the first laser fuse link is set with the laser beam.

## Description

### Background of the Invention

The present invention relates to the fabrication of integrated circuits. More particularly, the present invention relates to improved techniques for increasing circuit density and/or reducing substrate damage in an integrated circuit employing laser fuse links.

Semiconductor integrated circuits (IC) and their manufacturing techniques are well known. In a typical integrated circuit, a large number of semiconductor devices may be fabricated on a silicon substrate. To achieve the desired functionality, a plurality of conductors are typically provided to couple selected devices together. In some integrated circuits, some of the conductive links may be coupled to fuses, which may be cut or blown after fabrication using lasers. In a dynamic random access memory (DRAM) circuit, for example, fuses may be employed during manufacturing to protect some of the transistors' gate stacks from destruction due to inadvertent built-up charges. Once fabrication of the IC is substantially complete, the fuses may be blown or cut to permit the DRAM circuit to function as if the protective current paths never existed.

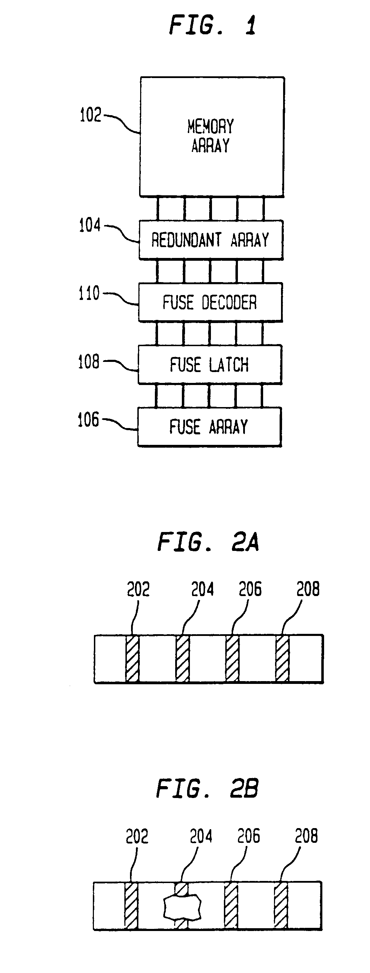

More commonly, fuses may be employed to set the enable bit and the address bits of a redundant array element in a DRAM circuit. To facilitate discussion, Fig. 1 illustrates a typical dynamic random access memory (DRAM) integrated circuit, including a main memory array 102. To facilitate replacement of a defective main array element within main memory array 102, a redundant array 104 is provided as shown. A plurality of fuses in fuse array 106 are coupled to redundant array 104 via a fuse latch array 108 and a fuse decoder circuit 110. To replace a defective main memory array element, individual fuses in fuse array 106 may be blown or cut to set their values to either a "1" or a "0" as required by the decoder circuit.

During operation, the values of the fuses in fuse array 106 are typically loaded into fuse latch array 108 upon power up. These values are then decoded by fuse decoder circuit 110 during run time, thereby facilitating the replacement of specific failed main memory array elements with specific redundant elements of redundant array 104. Techniques for replacing failed main memory array elements with redundant array elements are well known in the art and will not be discussed in great detail here for brevity's sake.

As mentioned earlier, the fuse links within fuse array 106 may be selectively blown or cut with a laser beam. Once blown by the laser beam, the fuse changes from a highly conductive state to a highly resistive, i.e., non-conductive, state, i.e., a blown fuse inhibits current from flowing through and represents an open circuit to the current path. With reference to Fig. 2A, fuse links 202, 204, 206, and 208 of fuse array element 106 are shown in their unblown, i.e., conductive, state. In Fig. 2B, a laser beam has been employed to cut or blow fuse link 204, thereby inhibiting the flow of current therethrough.

It has been found that the use of a laser beam to set, e.g., cut or blow, a fuse link may render the area under the fuse link vulnerable to laser-induced damage, mainly due to the absorption of laser energy during the fuse setting operation. In some cases, the area underlying the fuse link experiences a certain degree of laser-induced damage after the fuse setting operation. Because of the possibility of laser-induced damage, the areas underlying the fuse links are typically devoid of semiconductor devices (e.g., transistors) in the prior art.

Even when there are no active devices, the substrate itself may also experience some degree of laser-induced damage. This is because silicon, which is the typical substrate material, absorbs the laser energy readily, particularly when short wavelength lasers are employed. For this reason, lasers having relatively long wavelengths such as infrared lasers have been employed in the prior art for the fuse setting operation.

Even though infrared lasers are helpful in minimizing laser-induced damage to the underlying substrate, the use of lasers having relatively long wavelengths involves certain undesirable compromises. By way of example, the relatively long wavelength of the infrared laser forms a relatively large spot on the substrate during the fuse setting operation, which limits now closely the fuse links can be packed next to one another. For infrared lasers having a wavelength of, for example, about 1 micron, the spot created on the substrate may be two times the wavelength or about 2 to 2.5 microns wide.

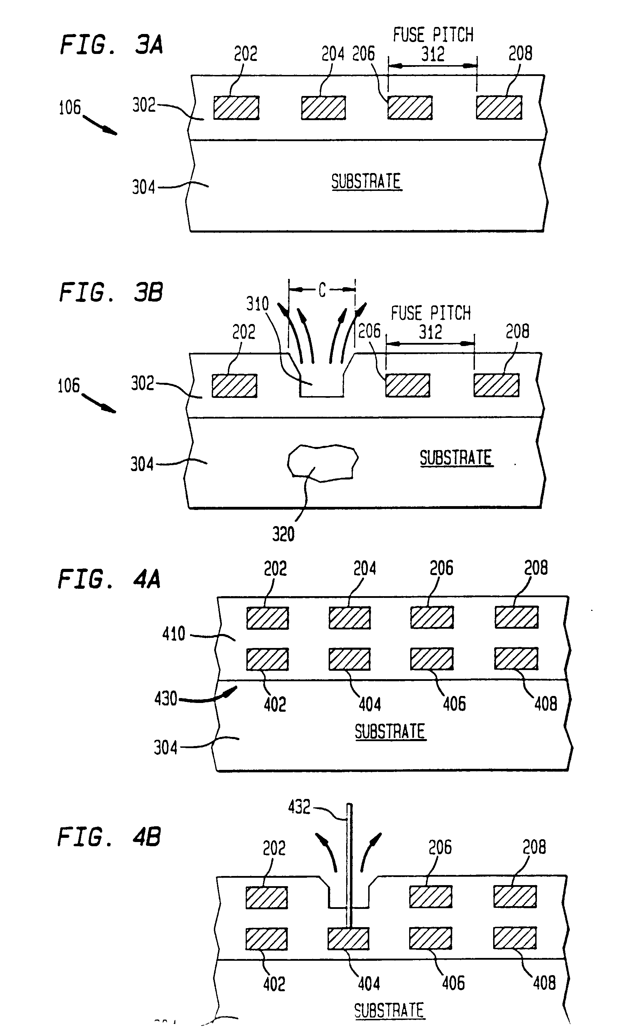

The disadvantages associated with lasers having relatively long wavelengths may be illustrated with reference to Figs. 3A and 3B below. Fig. 3A is a cross section view of a portion of fuse array 106, including fuse links 202, 204, 206, and 208. In Fig. 3A, fuse links 202, 204, 206, and 208 are shown encapsulated within a passivation layer 302. A substrate 304 underlies the fuse links as shown. It should be noted that the illustration of Fig. 3A is highly simplified to facilitate illustration and fuse array 106 may include other conventional layers and/or components as is known.

In Fig. 3B, fuse link 204 of Fig. 3A has been blown or cutting using a laser beam. In place of fuse link 204, a void 310 exists, whose diameter C is roughly twice the wavelength of the laser beam employed. The diameter C of the laser spot places a lower limit on the minimum fuse pitch 312 between adjacent fuse links. If the fuses are placed too closely together for a given laser wavelength, an adjacent fuse link may be inadvertently blown or cut, rendering the IC defective.

Using a laser with a shorter wavelength would reduce the diameter C of the laser spot and concomitantly the minimum fuse pitch. However, a shorter wavelength laser substantially increases the likelihood of underlying substrate damage in the prior art since the silicon substrate absorbs laser energy from shorter wavelength lasers much more readily. If shorter wavelength laser is employed to set the fuse links of the prior art fuse array 106, excessive substrate damage in area 320 may result, possibly leading to integrated circuit defects and failure.

In view of the foregoing, there are desired improved techniques for fabricating integrated circuits having laser fuse links. More particularly, there are desired improved laser fuse link structures and methods therefor, which advantageously minimizes substrate damage during the fuse setting operation and/or permit the use of shorter wavelength lasers to reduce the fuse pitch.

### Summary of the Invention

The present invention relates, in one embodiment, to an integrated circuit which includes a substrate and a shielding portion overlying the substrate. The integrated circuit further includes a first laser fuse link. The laser fuse link is configured to be set by a laser beam during fabrication of the integrated circuit. The first laser fuse link is disposed directly over the shielding portion, wherein the shielding portion is configured to substantially minimize laser-induced damage from the laser beam to a first area underlying the shielding portion when the first laser fuse link is set with the laser beam.

In another embodiment, the present invention relates to a dynamic random access memory integrated circuit implemented on a silicon substrate. The dynamic random access memory integrated circuit includes a main memory array having main memory array elements, and a redundant memory array coupled to the main memory array. The redundant memory array has redundant memory array elements, each of the redundant memory array elements being configured to replace a defective one of the main memory array elements. The dynamic random access memory integrated circuit includes a plurality of laser fuse links coupled to the redundant memory array. A first laser fuse link of the plurality of laser fuse links is configurated to be modified by laser beam during fabrication of the dynamic random access memory integrated circuit to set a value of an address fuse for a first one of the redundant memory array elements. The dynamic random access memory integrated circuit also includes a shielding portion underlying the first laser fuse link. The shielding portion is configured to substantially minimize laser-induced damage from the laser beam to a first area underlying the shielding portion when the first laser fuse link is set with the laser beam.

In yet another embodiment, the invention relates to a method in an integrated circuit for protecting an area underlying a laser fuse link from laser-induced damage when the laser fuse link is set by a laser beam. The method includes providing a silicon substrate, forming a shielding portion above the silicon substrate, and forming an insulating layer above the shielding portion. The method also includes forming the laser fuse link above the insulating layer. The laser fuse link is disposed directly over the shielding portion such that the shielding portion substantially minimizes the laser-induced damage from the laser beam to the area underlying the shielding portion when the laser fuse link is modified with the laser beam.

These and other advantages of the present invention will become apparent upon reading the following detailed descriptions and studying the various drawings.

### Brief Description of the Drawings

The present invention is illustrated by way of example, not by way of limitation, in the figures of the accompanying drawings and in which like reference numerals refer to like elements and in which:

Fig. 1 illustrates a typical dynamic random access memory (DRAM) integrated circuit to facilitate discussion.

Fig. 2A depicts a plurality of conventional laser use links in their unblown, i.e., conductive, state.

Fig. 2B depicts the laser fuse links of Fig 2A in their blown, i.e., nonconductive, state.

Figs. 3A and 3B illustrate a plurality of laser fuse links on a substrate, including the laser spots formed thereon after the fuse setting operation, to facilitate discussion of the disadvantages associated with lasers having relatively long wavelengths.

Fig. 4A depicts, in accordance with one aspect of the present invention, a cross sectional view of an improved integrated circuit wherein each laser fuse link is provided with an underlying shielding portion.

Fig. 4B depicts, in accordance with one aspect of the present invention, the manner in which the shielding portion reflects the laser beam away from the underlying area to protect it from laser-induced damage.

Fig. 5 is a plot illustrating the relationship between energy absorption and laser wavelengths for silicon.

Fig. 6 shows an alternative embodiment wherein the shielding portion is a blanket-deposited contiguous shielding layer.

Fig. 7 illustrates, in accordance with one aspect of the present invention, the steps involved in forming the improved laser fuse link.

### Detailed Description of the Preferred Embodiments

The present invention will now be described in detail with reference to a few embodiments thereof as illustrated in the accompanying drawings. In the following description, numerous specific details are set forth in order to provide a thorough understanding of the present invention. It will be apparent, however, to one skilled in the art, that the present invention may be practiced without some or all of these specific details. In other instances, well known process steps have not been described in detail in order to not unnecessarily obscure the present invention.

In accordance with one aspect of the present invention, laser fuse links are furnished with underlying shielding portions. The laser fuse links are used in, for example, integrated circuits (Ics) to enable connections in order to achieve the desired functionality. Such ICs include memory circuits like, for example, random access memories (RAMs), dynamic RAMs (DRAMs), synchronous DRAMs (SDRAMs), static RAMs (SRAMs), and read only memories (ROMs). Other ICs include logic devices such as programmable logic arrays (PLAs), application specific ICs (ASICs), or any circuit devices.

Typically, a plurality of ICs are fabricated on a semiconductor substrate, such as a silicon wafer, in parallel. After processing, the wafer is diced in order to separate the ICs into a plurality of individual chips. The chips are then packaged into final products for use in, for example, consumer products such as computer systems, cellular phones, personal digital assistants (PDAs), and other products. To simplify discussion of the invention, it is described in the context a single chip, and, more particularly, to a RAM chip.

By providing shielding portions, the underlying areas are protected by laser-induced damage when a laser beam is employed to set the laser fuse links. In one embodiment, the laser fuse links are insulated from the underlying shielding portion by a dielectric layer. With reduced substrate damage, the areas underlying the laser fuse links and the shielding portions may now be employed to implement semiconductor devices (e.g., transistors, capacitors, and the like), thereby increasing circuit density.

The provision of the shielding portions underlying the laser fuse links also facilitates the use of lasers whose wavelengths may be shorter than the wavelength of the prior art infrared laser. If such shorter wavelength lasers were employed on prior art laser fuse links, excessive damage to the underlying substrate may occur due to the excessive absorption of laser energy. With the shielding portions in place, the excess laser energy is either reflected away from the underlying areas or are absorbed by the shielding portions themselves, thereby minimizing laser-induced damage to the areas underlying the fuse links.

Since laser beams having shorter wavelengths may now be employed, adjacent laser fuse links may be packed more closely together, thereby increasing circuit density. By way of example, the use of shorter wavelength laser beams permits a greater number of fuse links to be implemented with the redundant array of the DRAM, thereby increasing the number of redundant array elements available for replacing defective main memory array elements.

The features and advantages of the present invention may be better appreciated with reference to the figures and discussion below. Fig. 4A depicts a cross sectional view of an improved Integrated circuit wherein each laser fuse link is provided with an underlying shielding portion. With reference to Fig. 4A, the laser fuse links 202, 204, 206, and 208 of Fig. 3A are again shown. The laser fuse links may be formed of aluminum or one of its alloys, or they may be formed of any order suitable fuse materials (e.g., polysilicon).

In Fig. 4A, laser fuse links 202, 204, 206, and 208 are provided with respective shielding portions 402, 404, 406, and 408 as shown. A shielding portion is preferably separated from its laser use link by a layer of insulating material. In the example of Fig. 4A, an oxide layer 410 insulates the laser fuse links from their respective shielding portions although any other type of dielectric material may be employed. On the other hand, if the shielding portions are provided as discrete pads (i.e., they are not interconnected), it is possible to have direct contact between a laser fuse link and its underlying shielding portion if desired. Similarly, if the shielding portions are formed of a nonconductive material, direct contact is possible even if the shielding portions are contiguous.

In general, the shielding portion is preferably formed of a material than reflects substantially all of the laser energy impacted upon it. Refractory metals such as tungsten, molybdenum, platinum, chromium, titanium, alloys thereof, or similar materials tend to work well. Although a material having a relatively high melting point (compared to the melting point of the laser fuse link) is preferred, materials having a substantially similar or even a lower melting point may also be employed as they may be appropriately sized to reflect or absorb enough of the laser energy to protect the underlying area. For example, the shielding portion may be formed of aluminum or one of its alloys or even a non metallic material such as silicon or polysilicon. In the preferred embodiment, the shielding portion is formed of a layer of tungsten about 3,500 angstroms thick.

A shielding portion such as shielding portion 402 is preferably sized, if the design permits, such that it is slightly wider than the size of its associated laser fuse link (e.g., laser use link 202). Being slightly larger, shielding portion 402 may be able to provide protection to areas underlying shielding portion 402 even if the laser beam is slightly off the center of laser fuse link 202 (due to, for example, alignment tolerance). Being slightly larger, the greater mass of material within shielding portion 402 also ensures protection against laser-induced damage of underlying area 430 in substrate 304. However, a shielding portion may have substantially the same dimension as its associated laser fuse link or maybe even smaller to increase circuit density. In these cases, some protection is still afforded since a shielding portion of an appropriate thickness may be able to absorb a substantial portion, and even most or all, of the excess laser energy, thereby minimizing or eliminating laser-induced damage to the underlying area.

In Fig. 4B, laser fuse link 204 has been blown by laser beam 432. As depicted in Fig. 4B, shielding portion 404 reflects laser beam 432 away from underlying area 434 to protect this area against laser-induced damage. Although the laser fuse links of Fig. 4A and 4B are shown encapsulated in a passivation layer, the presence of the passivation layer is not necessary in all cases.

Since the area underlying the shielding portion is substantially protected from laser-induced damage, the invention advantageously facilitates the use of the underlying area, e.g., area 434 in Fig. 4B, for implementing semiconductor devices. In contrast, the areas underlying the laser fuse links in the prior art are typically unpopulated with devices due to damage concerns. Further, the protection offered by the shielding portions makes it possible to employ lasers having shorter wavelengths to minimize the fuse pitch. As mentioned, infrared lasers are typically employed in the prior art since the use of lasers having shorter wavelengths tends to cause unacceptable damage to the underlying substrate due to excessive energy absorption.

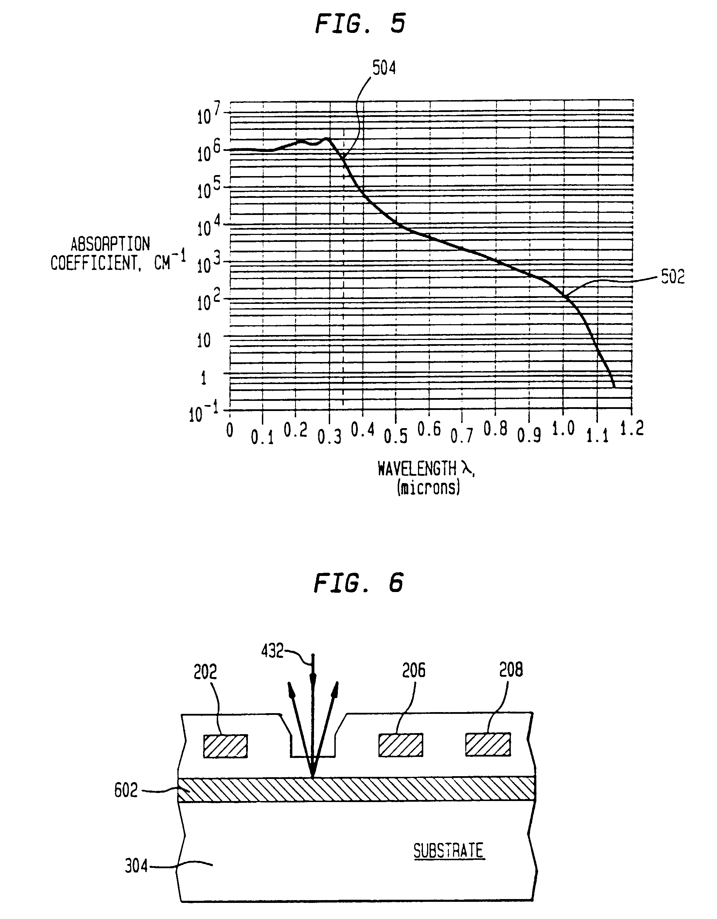

The relationship between energy absorption and laser wavelengths for silicon may be better appreciated with reference to the plot of Fig. 5. As shown in Fig. 5, energy absorption by the silicon substrate increases dramatically as the laser wavelength decreases. At about 1 micron, which is about the wavelength of prior art infrared lasers, the absorption coefficient is shown to be about 100/cm (point 502). For UV lasers, whose wavelenghts may be about 0.35 micron, the absorption coefficient is shown to be about 40,000/cm (point 504). Other substrate materials, such as GaAS, exhibit a similar trend. Accordingly, it is contemplated that the inventive fuse fabrication techniques disclosed herein apply to these substrates as well.

Because energy absorption increases logarithmically with decreasing wavelength, the trend in the prior art has been to employ lasers having longer wavelengths, even longer than wavelengths associated with prior art infrared lasers in some cases, to reduce energy absorption and substrate damage. The invention takes the opposite approach and facilitates the use of lasers having shorter wavelengths while substantially minimizing potential damage to the underlying substrate. With the provision of the shielding portion, it is now possible to employ, for example, sub-infrared lasers, ultraviolet lasers, visible lasers such as green lasers, blue lasers, red lasers, and the like in setting the laser fuse links.

The provision of the shielding portions is also nonobvious in that it requires additional structures to be fabricated on the substrate. This is contrary to the current trend, which strives to simplify the fabrication process and design complexity. In one particularly advantageous embodiment, however, the shielding portions themselves may be fabricated without requiring the provision of an additional layer or any additional process step. With reference to Fig. 4, shielding portions 402, 404, 406, and 408 may be advantageously formed from a suitable existing layer that underlies the fuse link layer. By way of example, some integrated circuits may have multiple metal layers, with the underlying metal layer performing the non-shielding function of interconnecting selected devices. In these cases, the shielding portions may be formed from that underlying metal layer by simply redesigning the mask employed for etching that underlying metal layer such than the shielding portions may also be formed from that underlying metal layer. In this manner, an existing underlying layer may perform both its original non-shielding function (e.g., interconnect) in some areas and the shielding function under the fuse link area. Although the underlying metal layer is employed as an example, any other suitable underlying layer may of course be employed.

It is not necessary in all cases to provide a separate shielding portion for each laser fuse link. Fig. 6 shows an alternative embodiment wherein the shielding portion is a blanket-deposited contiguous shielding layer 602. If shielding layer 602 is formed of a conductive material, e.g., a metallic material, it is of course preferably to insulate the laser fuse links from shielding layer 602 by at least one dielectric layer. To complete the illustration, laser beam 432 is shown reflected off shielding layer 602 after cutting away laser fuse link 204 of Fig. 4A.

If the shielding material is selected to reflect back the laser beam, the invention makes it possible to reduce the power setting of the laser beam since some of the reflected laser energy may assist in the fuse setting operation. With reduced laser power, less energy impacts the shielding portion, thereby permitting the shielding material to be thinner and/or offers a larger process window when changing the fuse link state. This is particularly true if the underlying shielding portions dishes out during processing. Dishing, as is well known, causes a shielding portion to assume a concave shape and is generally an undesirable phenomenon. Nevertheless, a concave shielding portion may more effectively focus the laser energy to the backside of the laser fuse link, thereby advantageously reducing the amount of energy needed to set a given laser fuse link. This is especially true if the radius of the curvature is substantially equal to the spacing between the shield and the use.

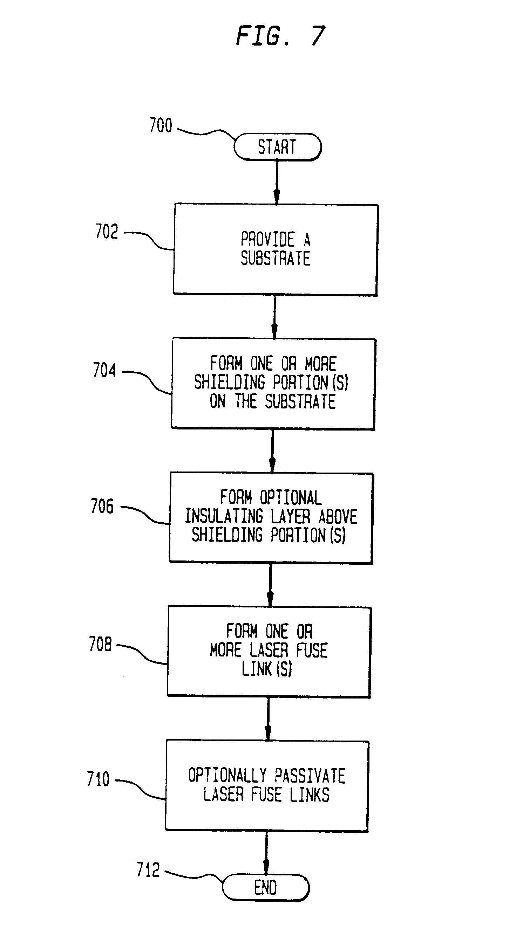

Fig. 7 illustrates, in accordance with one aspect of the present invention, the steps involved in forming an integrated circuit that offers greater protection to the areas underlying the fuse links from laser-induced damage during the fuse setting operation. In step 702, a substrate, which may be formed of silicon, is provided. In step 704, the shielding portions are formed above the substrate. As mentioned earlier, the shielding portion may represent discrete shielding portions (Fig.4A) or a blanket-deposited contiguous layer of shielding material (Fig.6 ). In step 706, an optional insulating layer is formed above the shielding portion. If the shielding portions are not interconnected or if they are formed of a nonconductive material, the insulating layer may be unnecessary. In step 708, the laser fuse links are formed. If desired, an optional passivation layer may be formed above the laser fuse links in step 710.

While this invention has been described in terms of preferred embodiments, there are alterations, permutations, and equivalents which fall within the scope of this invention. It should also be noted that there are many alternative ways of implementing the methods and apparatuses of the present invention. It is therefore intended that the following appended claims be interpreted as including all such alterations, permutations, and equivalents as fall within the true spirit and scope of the present invention.

## Claims

1. An integrated circuit, comprising:
a substrate;
a shielding portion overlying said substrate; and
a first laser fuse link, said laser fuse link being configured to be set by a laser beam during fabrication of said integrated circuit, said first laser fuse link being disposed directly over said shielding portion, wherein said shielding portion is configured to substantially minimize laser-induced damage from said laser beam to a first area underlying said shielding portion when said first laser fuse link is set with said laser beam.

2. The integrated circuit of claim 1 wherein said shielding portion is configured to reflect a substantial portion of laser energy incident on said shielding portion.

3. The Integrated circuit of claim 2 wherein said shielding portion is formed of a metallic material.

4. The integrated circuit of claim 1 wherein said shielding portion is configured to minimize said laser-induced damage below a level that causes said integrated circuit to be considered defective, said laser beam has a wavelength shorter than a wavelength associated with an infra-red laser.

5. The integrated circuit of claim 1 wherein said shielding portion is configured to minimize said laser-induced damage below a level that causes said integrated circuit to be considered defective, said laser beam is an ultraviolet laser beam.

6. The integrated circuit of claim 1 wherein said shielding portion is etched from a blanket-deposited layer of first material capable of substantially shielding said first area against laser-induced damage.

7. The integrated circuit of claim 6 wherein at least a portion of said first material performs a non-shielding function elsewhere on said integrated circuit.

8. The integrated circuit of claim 7 wherein said non-shielding function represents an interconnection function or interconnecting together selected devices on said integrated circuit, said blanket-deposited layer of first material represents a conductive layer.

9. A dynamic random access memory integrated circuit implemented on a silicon substrate, comprising:
a main memory array having main memory array elements;
a redundant memory array coupled to said main memory array, said redundant memory array having redundant memory array elements, each of said redundant memory array elements being configured to replace a defective one of said main memory array elements;
a plurality of laser fuse links coupled to said redundant memory array, a first laser fuse link of said plurality of laser fuse links being configured to be set by a laser beam during fabrication of said dynamic random access memory integrated circuit to set a value of an address fuse for a first one of said redundant memory array elements; and
a shielding portion underlying said first laser fuse link, said shielding portion being configured to substantially minimize laser-induced damage from said laser beam to a first area underlying said shielding portion when said first laser fuse link is set with said laser beam.

10. The dynamic random access memory integrated circuit of claim 9 wherein said shielding portion is etched from a blanket-deposited layer of first material capable of shielding against substantial laser-induced damage, wherein at least a portion of said first material performs a non-shielding function elsewhere on said dynamic random access memory integrated circuit.

11. The dynamic random access memory integrated circuit of claim 9 wherein said shielding portion is configured to reflect a substantial portion of laser energy incident on said shielding portion.

12. The dynamic random access memory integrated circuit of claim 11 wherein said shielding portion comprises a metal layer.

13. The dynamic random access memory integrated circuit of claim 9 wherein said laser beam has a wavelength shorter than about 1 micron.

14. The dynamic random access memory integrated circuit of claim 9 wherein said laser beam is an ultraviolet laser beam.

15. The dynamic random access memory integrated circuit of claim 9 wherein said first area represents an area for implementing semiconductor devices.

16. In an integrated circuit, a method for protecting an area underlying a laser fuse link from laser-induced damage when said laser fuse link is set by a laser beam, comprising:
providing a silicon substrate;
forming a shielding portion above said silicon substrate;
forming an insulating layer above said shielding portion;
forming said laser fuse link above said insulating layer, said laser fuse link being disposed directly over said shielding portion such that said shielding portion substantially minimizes said laser-induced damage from said laser beam to said area underlying said shielding portion when said laser fuse link is set with said laser beam.

17. The method of claim 16 wherein said forming said shielding portion includes forming said shielding portion out of a blanket-deposited metallic layer.

18. The method of claim 17 further comprising:
forming at least one semiconductor device in said area prior to forming said shielding portion.

19. The method of claim 16 wherein said laser beam represents a laser beam having a wavelength shorter than a wavelength of an infra-red laser beam.

20. A method for increasing capacity in an integrated circuit having laser fuse links, comprising:
providing a substrate;
forming a first shielding portion above said substrate;
forming an insulating layer above said first shielding portion;
forming said laser fuse links above said insulating layer, a first laser fuse link of said laser fuse links being disposed directly over said first shielding portion such that said first shielding portion substantially minimizes said laser-induced damage from said laser beam to a first area underlying said first shielding portion when said first laser fuse link is set with said laser beam.

21. The method of claim 20 further comprising:
forming a second shielding portion above said substrate, said second shielding portion being disposed below said insulating layer in said integrated circuit, wherein a second laser fuse link of said laser fuse links is disposed directly over said second shielding portion such that said second shielding portion substantially minimizes said laser-induced damage from said laser beam to a second area underlying said second shielding portion when said second laser fuse link is set with said laser beam.

22. The method of claim 21 wherein said first shielding portion and said second shielding portion are contiguous.

23. The method of claim 21 wherein said first shielding portion and said second shielding portion are made of a metallic material.

24. The method of claim 21 wherein said integrated circuit represents a dynamic random access memory circuit.

25. The method of claim 20 wherein said laser beam represents a laser beam having a wavelength shorter than a wavelength of an infra-red laser beam.
